Europäisches Patentamt

European Patent Office

Office européen des brevets

(11) Numéro de publication: **0 409 747 A1**

## DEMANDE DE BREVET EUROPEEN

(21) Numéro de dépôt: **90420330.4**

(22) Date de dépôt: **11.07.90**

(51) Int. Cl.5: **H03K 17/687**

(30) Priorité: **17.07.89 FR 8909912**

(43) Date de publication de la demande:
**23.01.91 Bulletin 91/04**

(84) Etats contractants désignés:
**AT BE CH DE ES FR GB GR IT LI LU NL SE**

(71) Demandeur: **SGS-THOMSON MICROELECTRONICS S.A.**
**7, Avenue Galliéni**
**F-94250 Gentilly(FR)**

(72) Inventeur: **Rischmüller, Klaus**
**Rue de l'Abbé de l'Epée**
**F-13000 Aix en Provence(FR)**

(74) Mandataire: **de Beaumont, Michel**
**1bis, rue Champollion**
**F-38000 Grenoble(FR)**

(54) **Circuit de commande de grille d'un transistor MOS.**

(57) La présente invention concerne un circuit de commande de la grille d'un transistor MOS de puissance (T) présentant une capacité d'entrée ($C_e$) dans lequel cette grille est en série avec une inductance (L), ce circuit comprend des moyens pour précharger l'inductance ; des premiers moyens (T2, T3) pour transférer l'énergie emmagasinée dans l'inductance vers la capacité d'entrée lors d'une commande de fermeture ; et des seconds moyens (T1, T4) pour transférer en retour vers l'inductance l'énergie stockée dans la capacité d'entrée lors d'une commande d'ouverture.

Figure 2

EP 0 409 747 A1

## CIRCUIT DE COMMANDE DE GRILLE D'UN TRANSISTOR MOS

La présente invention concerne de façon générale la commande d'un transistor MOS de puissance ou autre composant de puissance présentant une capacité d'entrée élevée.

Cette capacité d'entrée a un effet non négligeable du fait que de tels dispositifs sont oouramment commandés en commutation et que les fréquences de commutation deviennent de plus en plus élevées.

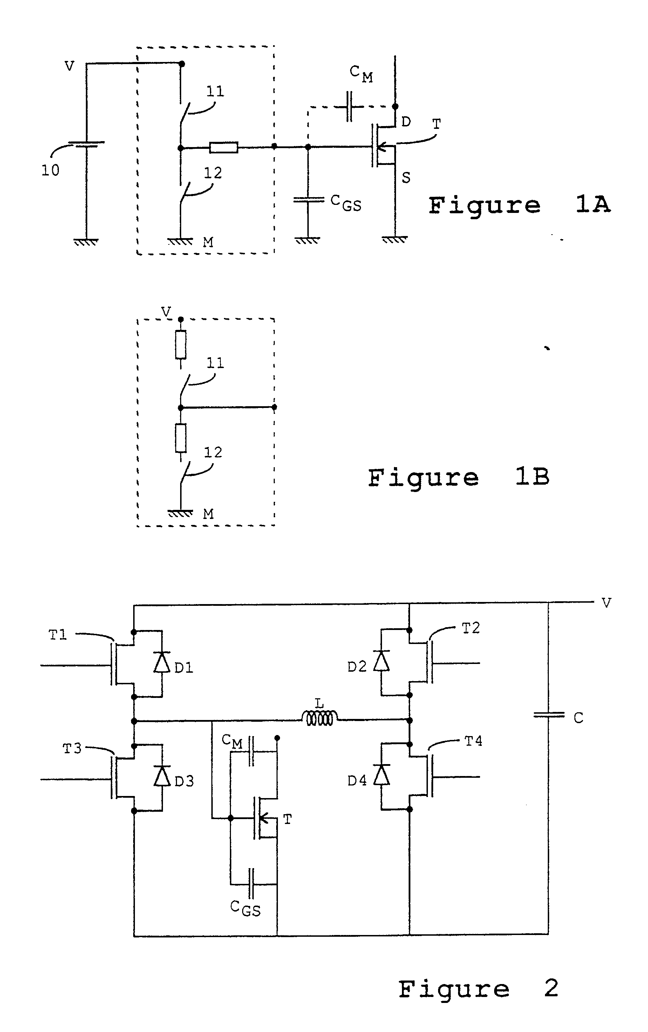

Les figures 1A et 1B illustrent deux variantes d'un montage élémentaire de commutation d'un transistor MOS de puissance T. Dans le cas représenté, le transistor T est relié par sa source à la masse et son drain est destiné à être connecté directement ou indirectement à une charge dans laquelle on veut commuter de l'énergie électrique. Ce transistor présente une capacité grille/source $C_{gs}$ et une capacité grille/drain qui est généralement appelée "capacité Miller" $C_m$. Si l'on veut commuter rapidement ce transistor, il faut charger et décharger rapidement la capacité d'entrée $C_e$ équivalente à l'ensemble des capacités $C_m$ et $C_{gs}$. Pour cela, on utilise des montages qui présentent les caractéristiques illustrées en figure 1A ou en figure 1B.

La grille G du transistor T peut être reliée ou bien à une borne d'alimentation 10 (tension V) ou bien à la masse M par l'intermédiaire d'interrupteurs 11 et 12. Toutefois, cette connexion présente généralement une résistance série qui peut être, ou bien, comme dans le cas de la figure 1A, disposée entre le point milieu des commutateurs et la grille, ou bien, comme dans le cas de la figure 1B, en série avec chacun des commutateurs 11 et 12. A chaque commutation on consommera dans la résistance impliquée une énergie $CV^2/2$ (cette énergie ne dépendant pas de la résistance mais seulement de la capacité de grille et de la tension appliquée). Si la fréquence devient très élevée, il se produit un grand nombre de commutations par seconde (un million à un mégahertz) et cette perte d'énergie qui était généralement considérée comme négligeable ne l'est plus. Si la capacité d'entrée a une valeur de 10 nF et que la tension d'entrée a une valeur de 15 volts, l'énergie consommée à chaque commutation est de 1,13 μJ, soit une consommation d'énergie de 1,13 J/s à 1 MHz.

On connaît également dans la technique, des montages dans lesquels il apparaît une inductance série sur la grille du transistor que l'on souhaite commander. Toutefois, cette inductance série est couplée par une résistance à une inductance de valeur L associée à un transformateur de charge et l'ensemble est destiné à déphaser la commande du transistor par rapport au courant dans le circuit principal de charge. Et on retrouve toujours dans ces circuits une consommation à chaque commutation de l'ordre de $CV^2/2$. En outre, ces circuits ne permettent pas de modifier la fréquence de commutation puisque celle-ci est liée à la fréquence de résonance du circuit et dépend donc des valeurs des inductances et capacités choisies.

Ainsi, un objet de la présente invention est de prévoir un circuit de commande de grille de transistor MOS de puissance à faible consommation.

Un autre objet de la présente invention est de prévoir un circuit de commande de grille de transistor MOS de puissance permettant de fournir sur la grille une tension supérieure à la tension de la source d'alimentation utilisée.

Un autre objet de la présente invention est de prévoir un tel circuit ne fonctionnant pas à une fréquence imposée.

Pour atteindre ces objets, la présente invention prévoit un circuit de commande de la grille d'un transistor MOS de puissance présentant une capacité d'entrée dans lequel cette grille est en série avec une inductance, comprenant des moyens pour précharger l'inductance ; des premiers moyens pour transférer l'énergie emmagasinée dans l'inductance vers la capacité d'entrée lors d'une commande de fermeture ; et des seconds moyens pour transférer en retour vers l'inductance l'énergie stockée dans la capacité d'entrée lors d'une commande d'ouverture.

Selon un mode de réalisation de la présente invention, il est prévu un condensateur auxiliaire dans lequel s'effectuent les transferts d'énergie provoqués par l'inductance.

Selon un mode de réalisation de la présente invention, le circuit de commande de grille comprend quatre interrupteurs munis de diodes antiparallèle montés en pont, une diagonale du pont étant reliée à une source d'alimentation avec un condensateur en parallèle et l'autre diagonale du pont étant reliée par une inductance, l'une des bornes de cette inductance étant connectée à la grille du transistor MOS de puissance.

Selon un mode de réalisation de la présente invention, les moyens de précharge d'inductance sont reliés entre cette inductance et la grille du transistor MOS, les premiers moyens de transfert d'énergie comprennent un commutateur en série avec une diode d'une première polarité et les seconds moyens de transfert comprennent un interrupteur et une diode de polarité opposée.

Selon un mode de réalisation de la présente invention, la borne de l'inductance non connectée à la grille est reliée à une première borne du montage en parallèle d'une première diode et d'un interrupteur avec une seconde diode et un autre interrupteur, les diodes étant de polarités opposées, l'autre borne de ce montage en parallèle étant reliée à la première borne du condensateur auxiliaire et à des moyens de précharge.

Ainsi, selon la présente invention, il y a en théorie une consommation de puissance nulle dans la grille, l'énergie étant chaque fois récupérée. Le seul apport d'énergie est l'apport d'énergie initial de $CV^2/2$ nécessaire à la première commutation.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A et 1B décrites précédemment illustrent des circuits de commande de grille classiques ;

la figure 2 représente un premier mode de réalisation d'un circuit de commande de grille selon la présente invention ;

les figures 3 et 4 représentent des chronogrammes de fonctionnements possibles du circuit de la figure 2 ;

la figure 5 représente un deuxième mode de réalisation de la présente invention ;

la figure 6 représente des chronogrammes associés au fonctionnement du circuit de la figure 5 ;

la figure 7 représente un troisième mode de réalisation d'un circuit selon la présente invention ;

la figure 8 représente des chronogrammes illustrant le fonctionnement du circuit de la figure 7 ; et

la figure 9 représente un quatrième mode de réalisation d'un circuit selon la présente invention.

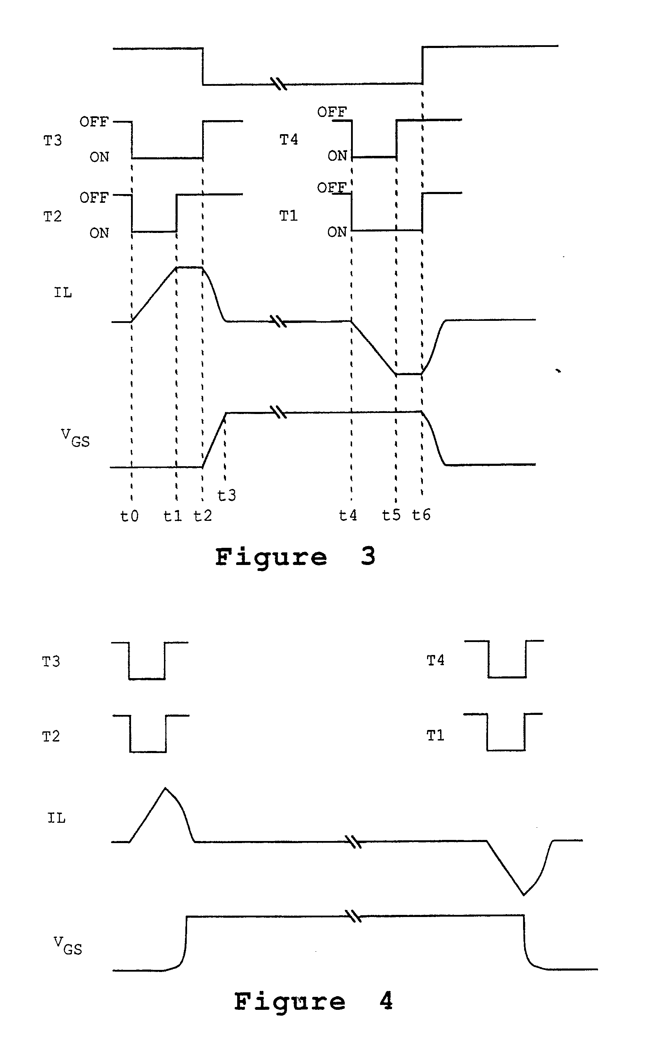

On retrouve dans la figure 2 le transistor de puissance T de la figure 1 avec ses capacités d'entrée $C_{gs}$ et $C_m$ équivalant à une capacité d'entrée $C_e$. Le circuit comprend quatre interrupteurs représentés sous forme de transistors MOS T1 à T4 comprenant chacun une diode anti-parallèle D1 à D4. Les drains communs des transistors T1 et T2 sont reliés à une source d'alimentation, les sources communes des transistors T3 et T4 sont reliées à la masse, la source du transistor T1 est reliée au drain du transistor T3 et la source du transistor T2 est reliée au drain du transistor T4. Le point de connexion des transistors T1 et T3 est relié au point de connexion des transistors T2 et T4 par l'intermédiaire d'une inductance L. En outre, l'une des bornes de cette inductance est reliée à la grille du transistor de puissance T que l'on veut commuter. On a également représenté un condensateur C en parallèle sur la source d'alimentation V.

Le fonctionnement de ce circuit va être expliqué en relation avec les chronogrammes illustrés en figure 3. On suppose qu'initialement tous les transistors T1 à T4 sont bloqués et que le transistor T est bloqué. A l'instant initial, t0, on met en conduction les transistors diagonalement opposés T2 et T3. Ceci provoque la circulation d'un courant dans l'inductance L, ce courant croissant jusqu'à que le transistor T2 soit bloqué à un instant t1. Pendant cette durée, on a atteint un courant $I_1$ et emmagasiné dans l'inductance une énergie $LI_1{}^2/2$. Comme on le verra ci-après, c'est la seule consommation d'énergie demandée à la source. Après l'instant t1, le courant tourne en passant par le transistor T3 et la diode D4. Si alors, à un instant t2, le transistor T3 est bloqué, de l'énergie se transfère de l'inductance dans la capacité d'entrée $C_e$ du transistor T dont la tension $V_{gs}$ croît jusqu'à un instant t3 auquel la tension sur la capacité a atteint la valeur V et une limitation se produit sous l'effet de la diode D1 et l'excès d'énergie éventuel dans l'inductance L est renvoyé à la source (sur le condensateur C) par un chemin passant par les diodes D4 et D1 jusqu'à démagnétisation de l'inductance.

Pour bloquer le transistor T, on rend passant le transistor T4 et le transistor T1. Dans un premier temps, du courant circule dans la boucle comprenant la capacité d'entrée, l'inductance L et le transistor T4 à l'état passant et l'énergie stockée dans la capacité est transférée à partir de l'instant t4 dans l'inductance L dans laquelle circule un courant $I_1$ de sens inverse de celui considéré précédemment. A un instant t5, le transistor T4 est bloqué, l'inductance L garde son énergie et le courant $I_1$ tourne dans la boucle constituée par le transistor T1, l'inductance L et la diode D2. Quand le transistor T1 est bloqué, à l'instant t6, l'énergie dans l'inductance est renvoyée à la source par l'intermédiaire du trajet comprenant la diode D3, l'inductance L et la diode D2.

On obtient ainsi des transferts d'énergie de la capacité-réservoir C de la source vers l'inductance L, puis de l'inductance L vers la capacité d'entrée $C_e$ du transistor de puissance, puis des transferts inverses d'énergie de $C_e$ vers L et de L vers C. Ainsi, d'un point de vue théorique, ce circuit peut fonctionner de façon répétée sand consommation d'énergie. Toutefois, en raison des pertes inhérentes à tout circuit électrique, il sera prudent de prévoir une recharge régulière du condensateur C par une source d'alimentation V, bien qu'en théorie cette source d'alimentation ne doive servir qu'à la charge initiale du condensateur-réservoir C.

La figure 4 représente un autre chronogramme de fonctionnement possible du circuit selon la présente invention dans lequel, à la fermeture, les transistors T3 et T2 sont bloqués simultanément et, à l'ouverture, les transistors T4 et T1, c'est-à-dire qu'il n'y a pas de phase de fonctionnement intermédiaire en roue libre de la charge dans l'inductance L.

Selon un avantage supplémentaire de la présente invention, on notera que, comme cela est connu de l'homme de l'art, le fait d'injecter des charges dans la capacité d'entrée ou de décharger la capacité d'entrée d'un transistor de puissance par l'intermédiaire d'une self permet d'obtenir des temps de charge et de décharge plus rapides qu'avec des résistances.

On notera également que le circuit de commande de grille selon la présente invention est indépendant du circuit principal du transistor de puissance et que sa fréquence de fonctionnement peut être choisie librement.

En outre, pour des raisons d'optimisation, l'homme de l'art pourra préférer placer un condensateur supplémentaire en parallèle sur la capacité d'entrée $C_e$.

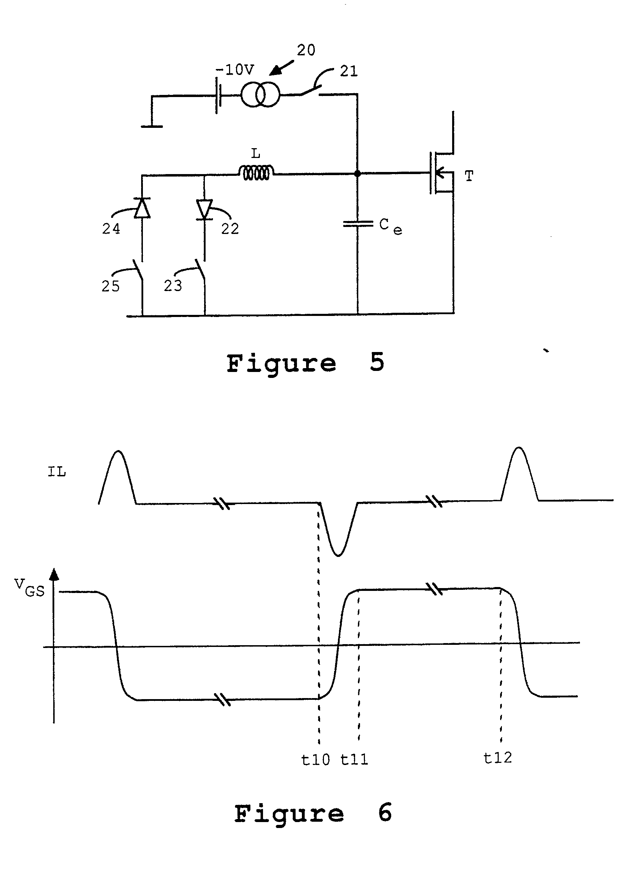

La figure 5 illustre un autre mode de réalisation de la présente invention. On y retrouve le transistor de puissance T, sa capacité d'entrée $C_e$, et une inductance L. Une source auxiliaire 20 permet de précharger la capacité $C_e$ à une tension négative choisie, par exemple -10 volts. Cette source auxiliaire peut être isolée du circuit d'entrée par un interrupteur 21. L'inductance L est reliée à la masse d'une part par l'intermédiaire d'une première diode 22 en série avec un interrupteur 23, d'autre part par l'intermédiaire d'une seconde diode 24 en série avec un interrupteur 25, les diodes 22 et 24 étant de polarité opposée. Les interrupteurs 23 et 25 peuvent classiquement être des transistors MOS tels que décrits précédemment.

Le fonctionnement du circuit de la figure 5 va être décrit en relation avec la figure 6 qui illustre le courant IL dans l'inductance et la tension $V_{gs}$ sur la grille du transistor de puissance T.

Si l'on part de l'état initial à l'instant t10 où la capacité est chargée sous -10 volts et où aucun courant ne circule dans l'inductance et que l'on ferme l'interrupteur 25, un courant négatif va circuler dans la diode et la polarité aux bornes du condensateur va s'inverser pour passer d'une valeur négative, par exemple -10 volts, à une valeur positive, par exemple +10 volts, à un instant t11, instant auquel l'interrupteur 25 est réouvert (on notera que cette valeur positive peut dépasser 10 V si l'on ferme l'interrupteur 25 pendant une durée plus longue). La charge se maintient alors normalement sur le condensateur pour s'inverser à nouveau à partir de l'instant t12 où l'interrupteur 23 est fermé.

Ainsi, grâce à des transferts d'énergie répétés sur la capacité $C_e$ par l'intermédiaire de l'inductance L, on arrive à commander des commutations du transistor T sans consommation d'énergie.

Toutefois, en raison des pertes inhérentes à tout circuit, on prévoira de refermer régulièrement l'interrupteur 21 pendant des phases de charge négative de la grille pour compenser les pertes en rechargeant négativement la capacité $C_e$.

On notera que dans ce mode de réalisation on peut considérer la capacité $C_e$ tantôt comme la capacité de grille qui se charge pour entraîner la conduction du transistor de puissance T tantôt comme un condensateur auxiliaire qui se charge en inverse pour stocker les charges nécessaires à la charge ultérieure selon l'autre polarité de cette capacité.

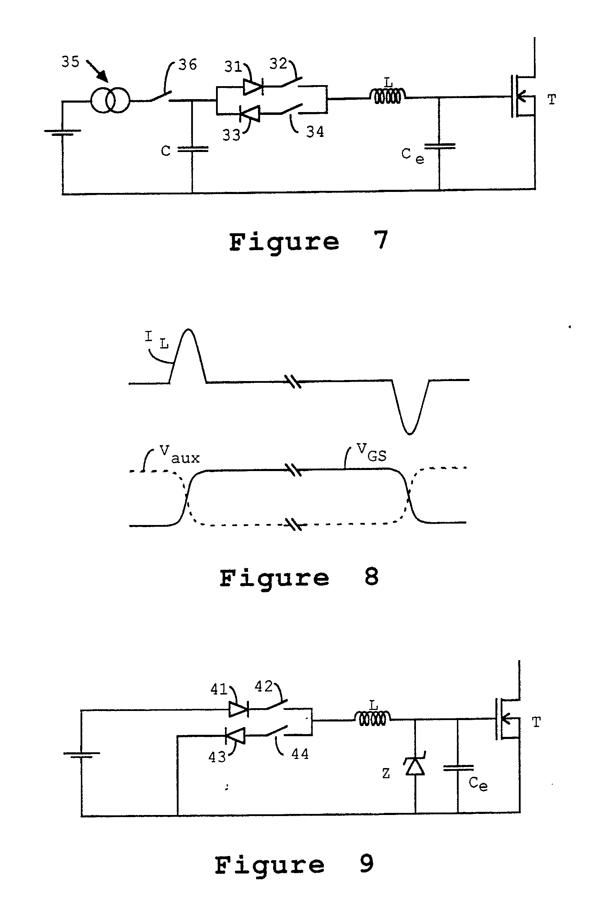

La figure 7 représente un troisième mode de réalisation de la présente invention dans lequel on trouve avec les mêmes références des composants existant dans les modes de réalisation précédents. La deuxième borne de l'inductance L, non connectée à la grille du transistor de puissance T est reliée à un condensateur auxiliaire C dont l'autre borne est à la masse par l'intermédiaire du montage en parallèle d'une première diode 31 en série avec un interrupteur 32 et d'une deuxième diode 33 en série avec un interrupteur 34. La diode 31 est polarisée en inverse par rapport à la diode 33. Là encore, comme dans le mode de réalisation précédent, les charges sont échangées par l'intermédiaire de l'inductance L entre la capacité $C_e$ et le condensateur auxiliaire C qui peut être considéré comme une capacité réservoir initialement chargée et périodiquement rechargée par une source de courant 35 pendant des durées déterminées par un interrupteur 36.

En figure 8, en a représenté la variation du courant $I_1$ en fonction de la commutation des interrupteurs 32 et 34 ainsi que la variation de la tension de grille $V_{gs}$ du transistor de puissance T, et, en pointillés, la variation de charge sur le condensateur auxiliaire C.

La figure 9 représente un quatrième mode de réalisation de la présente invention dans lequel on trouve avec les mêmes références des composants existant dans les modes de réalisation précédents. La deuxième borne de l'inductance L, non connectée à la grille du transistor de puissance T, est reliée à un montage en parallèle d'une première diode 41 en série avec un interrupteur 42 et d'une deuxième diode 43 en série avec un interrupteur 44. La diode 41 est polarisée en inverse par rapport à la diode 43. La diode 41 est reliée à une source d'alimentation positive et la diode 43 est reliée à la masse. En outre une diode zener Z est connectée aux bornes de la capacité $C_e$. Ainsi, à chaque fermeture de l'interrupteur 42, $C_e$ se charge à une tension limitée par la diode zener et qui peut être supérieure à celle de la source d'alimentation positive. Ce mode de réalisation satisfait au deuxième objet de l'invention.

L'homme de l'art pourra envisager de nombreuses variantes à la présente invention dont l'aspect fondamental réside dans le fait que, pour un interrupteur de puissance présentant une capacité d'entrée et commandé en commutation, la commande est effectuée par transfert de charge entre sa capacité d'entrée et un condensateur auxiliaire par l'intermédiaire d'une inductance servant au stockage de l'énergie. Dans un mode de réalisation particulier de l'invention, la capacité d'entrée peut elle-même servir de condensateur auxiliaire pendant les phases de blocage du transistor de puissance.

**Revendications**

1. Circuit de commande de la grille d'un composant de puissance à entrée capacitive tel qu'un transistor MOS de puissance (T) présentant une capacité d'entrée ($C_e$) dans lequel cette grille est en série avec une inductance (L), caractérisé en ce qu'il comprend :
- des moyens pour précharger l'inductance ;
- des premiers moyens pour transférer l'énergie emmagasinée dans l'inductance vers la capacité d'entrée lors d'une commande de fermeture ; et
- des seconds moyens pour transférer en retour vers l'inductance l'énergie stockée dans la capacité d'entrée lors d'une commande d'ouverture.

2. Circuit de commande de grille selon la revendication 1, caractérisé en ce qu'il comprend en outre un condensateur auxiliaire (C) dans lequel s'effectuent les transferts d'énergie provoqués par l'inductance.

3. Circuit de commande de grille selon la revendication 1, caractérisé en ce qu'il comprend quatre interrupteurs (T1-T4) munis de diodes anti-parallèle (D1-D4) montés en pont, une diagonale du pont étant reliée à une source d'alimentation avec un condensateur en parallèle et l'autre diagonale du pont étant reliée par une inductance, l'une des bornes de cette inductance étant connectée à la grille du transistor MOS de puissance.

4. Circuit de commande de grille selon la revendication 1, caractérisé en ce que les moyens de précharge d'inductance (20, 21) sont reliés entre cette inductance et la grille du transistor MOS, en ce que les premiers moyens de transfert d'énergie comprennent un commutateur (25) en série avec une diode (24) d'une première polarité et en ce que les seconds moyens de transfert comprennent un interrupteur (23) et une diode (22) de polarité opposée.

5. Circuit de commande de grille selon la revendication 2, caractérisé en ce que la borne de l'inductance non connectée à la grille est reliée à une première borne du montage en parallèle d'une première diode (33) et d'un interrupteur (34) avec une seconde diode (31) et un autre interrupteur (32), les diodes étant de polarité opposées, l'autre borne de ce montage en parallèle étant reliée à la première borne du condensateur auxiliaire (C) et à des moyens de précharge (35, 36).

Figure 1A

Figure 1B

Figure 2

Figure 3

Figure 4

7

Figure 5

Figure 6

**Figure 7**

**Figure 8**

**Figure 9**

Office européen
des brevets

**RAPPORT DE RECHERCHE EUROPEENNE**

Numero de la demande

EP 90 42 0330

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | DE-A-3 813 672 (SIEMENS) * Colonne 6, ligne 9 - colonne 9, ligne 38; figures 3-5 * | 1-3 | H 03 K 17/687 |
| Y | | 4,5 | |
| | --- | | |
| X | IEEE TRANSACTIONS ON CIRCUITS AND SYSTEMS, vol. 35, no. 2, février 1988, pages 254-256; M.K. KAZIMIERCZUK: "High-speed driver for switching power MOSFET's" * Page 254, colonne de droite, dernier alinéa - page 255, colonne de droite, ligne 38; figures 1,2(b) * | 1 | |
| | --- | | |
| Y | US-A-3 337 748 (RUSCH et al.) * Colonne 7, lignes 14-57; figure 7 * | 4,5 | |
| | ----- | | |

DOMAINES TECHNIQUES RECHERCHES (Int. Cl.5)

H 03 K
H 03 F

Le présent rapport a été établi pour toutes les revendications

| Lieu de la recherche | Date d'achèvement de la recherche | Examinateur |
|---|---|---|
| LA HAYE | 24-10-1990 | CANTARELLI R.J.H. |

EPO FORM 1503 03.82 (P0402)